# EUROPÄISCHE PATENTSCHRIFT

(11) **EP 1 442 646 B1**
(45) Veröffentlichungstag und Bekanntmachung des Hinweises auf die Patenterteilung: **28.02.2007**
(21) Anmeldenummer: 02802632.6
(22) Anmeldetag: 26.10.2002
(51) Int. Cl.: H05K 13/00

(54) **VORRICHTUNG ZUM TRANSPORT VON FLEXIBLEM FLACHMATERIAL, INSBESONDERE LEITERPLATTEN**
DEVICE FOR THE TRANSPORT OF FLEXIBLE PLANAR MATERIAL, IN PARTICULAR CIRCUIT BOARDS
DISPOSITIF POUR TRANSPORTER DES PRODUITS PLATS FLEXIBLES, EN PARTICULIER DES CARTES IMPRIMEES

(30) Priorität: 05.11.2001 DE 10154884
(43) Veröffentlichungstag der Anmeldung: 04.08.2004
(73) Patentinhaber: Gebr. Schmid GmbH & Co., D-72250 Freudenstadt (DE)
(72) Erfinder: KAPPLER, Heinz, 72280 Dornstetten-Aach (DE)
(74) Vertreter: Patentanwälte Ruff, Wilhelm, Beier, Dauster & Partner
(86) Internationale Anmeldenummer: PCT/EP2002/011990
(87) Internationale Veröffentlichungsnummer: WO 2003/041475

(56) Entgegenhaltungen:
- DE-A- 4 339 092
- US-A- 5 791 453

## Beschreibung

### Anwendungsgebiet und Stand der Technik

Die Erfindung bezieht sich auf eine Vorrichtung zum Transport von flexiblem platten- bzw. blattförmigem Flachmaterial, insbesondere Leiterplatten in Behandlungseinrichtungen, wobei das Flachmaterial in Randbereichen erfasst wird.

Leiterplatten für elektrische Schaltungen, zur Anordnung elektronischer Bauelemente etc. bestehen normalerweise aus einem elektrisch isolierenden Substrat, auf dem durch optische, chemische bzw. elektrochemische Verfahren Leiterbahnen angebracht werden. Dies geschieht in Behandlungseinrichtungen, in denen die Leiterplatte meist mit flüssigen Behandlungsmitteln behandelt werden, wie Entwickeln eines Fotoresist, Ätzen, Reiben etc.. Die Substrate sind dabei teilweise sehr dünn und haben teilweise nur noch eine Dicke von 25 µm mit einer Beschichtung von 5 µm. Sie sind daher, da sie aus flexiblem Material bestehen, fast nur noch blatt- bzw. folienartig.

Diese Flachmaterialien werden in den Behandlungseinrichtungen, auch abhängig von der Art der Behandlung, auf verschiedene Arten transportiert, vorwiegend zwischen Walzen- oder Rollenpaaren (DE 196 28 784 A), wobei sie, beispielsweise in einer Galvanikeinrichtung, im Randbereich von elektrischen Kontaktrollen kontaktiert werden.

Es sind auch bereits Einrichtungen bekannt, die nach Art Taumelscheiben ausgebildet sind, um die für viele Behandlungen schädliche streifenförmige Abdeckung durch die Rollenpaare zu verhindern (vgl. DE 197 48 337 A).

Es ist auch schon bekannt geworden (DE 195 09 313), Leiterplatten, die nur einseitig behandelt werden, durch vakuumbeaufschlagte Bänder "hängend" zu transportieren.

Es ist ferner aus der DE 43 39 263 A1 bekannt geworden, Leiterplatten durch Behandlungseinrichtungen zu führen, in denen ihre Randbereiche auf Saugbändern geführt werden, die im Sinne einer Spreizung auseinander geführt sind. Dadurch ist es zwar möglich, den Mittelbereich der Leiterplatte im wesentlichen berührungsfrei zu führen, jedoch ist der von den Bändern beanspruchte Randbereich sehr breit, was meist nicht akzeptiert wird. Ferner kann bei der Nassbehandlung, insbesondere mit aggressiven Chemikalien, die in die Saugeinrichtung eventuell hineingezogene Flüssigkeit Probleme bereiten.

### Aufgabe und Lösung

Aufgabe der Erfindung ist es, eine Vorrichtung zu schaffen, mit der das Flachmaterial berührungsfrei und ohne wesentliche Einschränkung des nutzbaren Bereiches durch die Behandlungseinrichtung transportiert werden kann.

Diese Aufgabe wird durch die Merkmale des Anspruchs 1 gelöst. Die aus aufeinander bzw. auf das Flachmaterial gedrückten Rollenpaare sind in Rollenbahnen angeordnet, die auf einem parallel zur Transportrichtung verlaufenden Außenrand der Flachmaterialien laufen und somit den nutzbaren Mittelbereich kaum beeinträchtigen. Zwar wird dieser Bereich durch die nach außen wirkende Zugbeanspruchung, die auch zu einer gewissen nach außen gerichteten Relativbewegung zwischen den Kontaktflächen der Rollen und der Oberfläche des Flachmaterials führt, stärker beansprucht, aber diese Flächen sind ohnehin für die Leiterplatten unerheblich. Trotz der stets nach außen gerichteten Laufrichtung der Rollen, d.h. einer in Querrichtung zur Transportrichtung gerichteten Transportkomponente bleibt die Rollenbahn auf einen schmalen parallelen Streifen beschränkt. Jede der Rollen erzeugt also eine Zugkraft nach außen, die entlang des Flachmaterialrandes wandert.

Der Winkel, unter den die Rollen gegenüber der Transportrichtung angestellt sind, kann außerordentlich klein sein und liegt im Bereich von Bruchteilen von Geraden bis zu wenigen Graden, insbesondere bei 0,5°.

Die Erfindung ermöglicht es also, die Flachmaterialien, insbesondere Leiterplatten, berührungsfrei durch die Behandlungseinheiten zu führen. Es ist dabei nicht zu befürchten, dass die empfindlichen Oberflächen, beispielsweise ein feuchtes Fotoresist, durch die Walzen beschädigt werden, die auf der zu behandelnden Oberfläche laufen, wie dies beim Stand der Technik meist der Fall war. Auch können keine Schmutzpartikel durch die Walzen "aufgewalzt" werden.

Bei etwas steiferen Flachmaterialien ist es auch möglich, eine gewisse Druckspannung aufzubringen, so dass z.B. eine nach oben gerichtete Wölbung oder Bombierung auftritt. Dazu können vorzugsweise die Kontaktflächen das Flachmaterial unter einem Winkel zur Ebene des Flachmaterials erfassen und führen, so dass die Ränder leicht nach oben gerichtet werden. Diese Ausführung erlaubt ein besonders gutes Ablaufen von Flüssigkeiten, so dass keine "Pfützen" auf der Oberfläche entstehen können, die die Gleichmäßigkeit der Behandlung beeinträchtigen könnten.

In diesem Zusammenhang wird darauf hingewiesen, dass ein "bombierter Transport" in der DE 195 24 562 beschrieben ist, dort allerdings mit anderen Merkmalen und Mitteln.

Eine Vorrichtung nach der Erfindung ermöglicht es auch, das Transportsystem unterschiedlichen Breiten von Flachmaterialien anzupassen. Dazu ist eine Abstands-Verstelleinrichtung vorgesehen, die den Abstand der Rollenbahnen voneinander verstellt. Diese sind vorzugsweise synchron angetrieben und können auch synchron entgegengesetzt zueinander verstellt werden. Einzelheiten dazu sind in den Unteransprüchen beschrieben.

Die Erfindung schafft also bei einer bevorzugten Ausführungsform ein Transportsystem für Leiterplatten, das die Leiterplatten zwischen Rollenpaaren führt. Die Rollenpaare sind in Rollenbahnen angeordnet, die parallel zum Rand der Leiterplatte in einem eng begrenzten Randbereich laufen. Die Rollen sind mit ihren Achsen und Wellen unter einem Winkel gegenüber der Transportrichtung bzw. der Senkrechten dazu angeordnet, so dass sie eine in Querrichtung wirkende Zugspannung auf die Leiterplatten ausüben und diese dadurch versteifen. Dadurch ist ein im Nutzbereich der Leiterplatte berührungsloser Transport durch die Behandlungseinrichtungen, wie Galvanisieren, Ätzen, Reinigen etc. möglich.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischenüberschriften beschränkt die unter diesen gemachten Aussagen nicht in ihrer Allgemeingültigkeit.

### Kurzbeschreibung der Zeichnungen

Ein Ausführungsbeispiel der Erfindung ist in den Zeichnungen dargestellt und wird im folgenden näher erläutert. In den Zeichnungen zeigen:
- Fig. 1: eine Draufsicht auf eine Behandlungseinrichtung mit der Transporteinrichtung nach der Erfindung,
- Fig. 2: einen Schnitt nach der Linie II-II in Fig. 1,
- Fig. 3: den Schnitt nach Fig. 2 in einer anderen Breiten-Einstellung des Transportsystems,
- Fig. 4: eine Ansicht nach der Linie IV-IV in Fig. 1,
- Fig. 5: eine schematische Darstellung der Winkelstellung der Rollen,
- Fig. 6: einen Detailschnitt entsprechend der rechten Hälfte von Fig. 2, jedoch mit einer anderen Ver-Stelleinrichtung,
- Fig. 7: das Detail von Fig. 5 in einer anderen Einstellung der Transportbreite und
- Fig. 8: einen schematischen Querschnitt durch eine Vor-Richtung mit gewölbter Transportbahn.

### Beschreibung der Ausführungsbeispiele

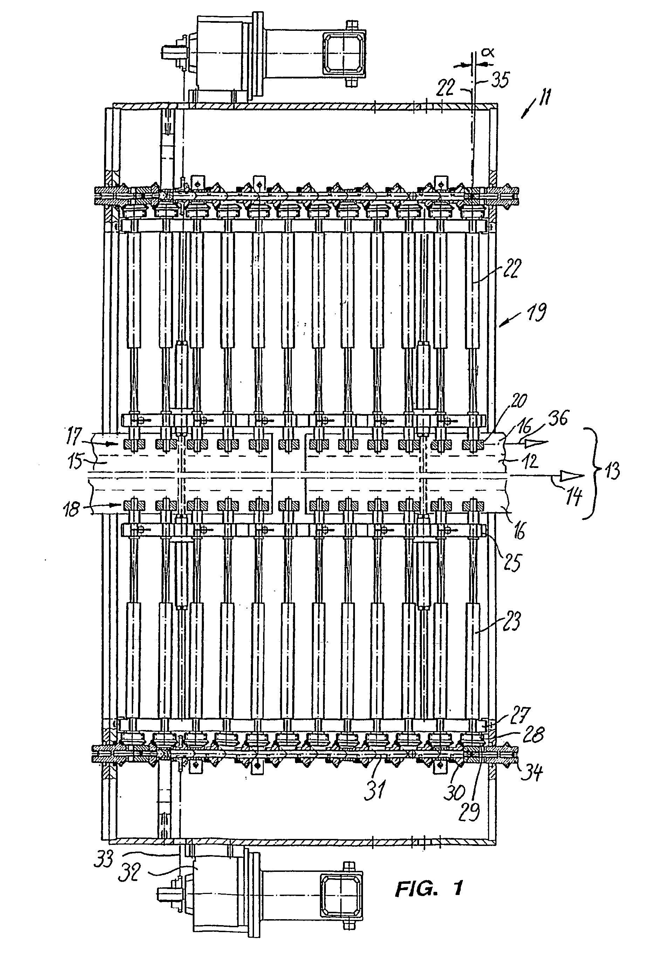

Fig. 1 zeigt eine Behandlungseinrichtung 11 für Leiterplatten 12. Die Behandlungseinrichtung 11 besteht im wesentlichen aus einem Trog, in dessen Behandlungsbereich 13 ein Behandlungsmedium, beispielsweise eine Flüssigkeit, auf die Leiterplatten einwirkt. Dazu können dort nicht dargestellte Sprühdüsen, Absaugungen o.dgl. angeordnet sein.

Die im wesentlichen blattförmigen, aus Flachmaterial wie faserverstärkten Kunststoffen o.dgl. bestehenden Leiterplatten werden horizontal in Transportrichtung 14 durch die Behandlungseinrichtung geführt, wobei sie normalerweise durch eine Eintritts- und Austrittsschleuse geführt werden. Die dargestellte Behandlungseinrichtung ist in Transportrichtung sehr kurz. Viele dieser Einrichtungen sind jedoch wesentlich länger.

Die dünnen, flexiblen Leiterplatten 12 haben einen nutzbaren Bereich 15, auf den Leiterbahnen aufgebracht werden, und an beiden Rändern parallel zur Transportrichtung verlaufende Randbereiche 16, die normalerweise frei von Leiterbahnen oder anderen Funktionselementen sind. In diesen Randbereichen greifen Rollenbahnen 17, 18 an der Leiterplatte an, die zu Transportmitteln 19 gehören, die dazu vorgesehen sind, die Leiterbahnen in Transportrichtung durch die Behandlungseinrichtung 11 zu transportieren.

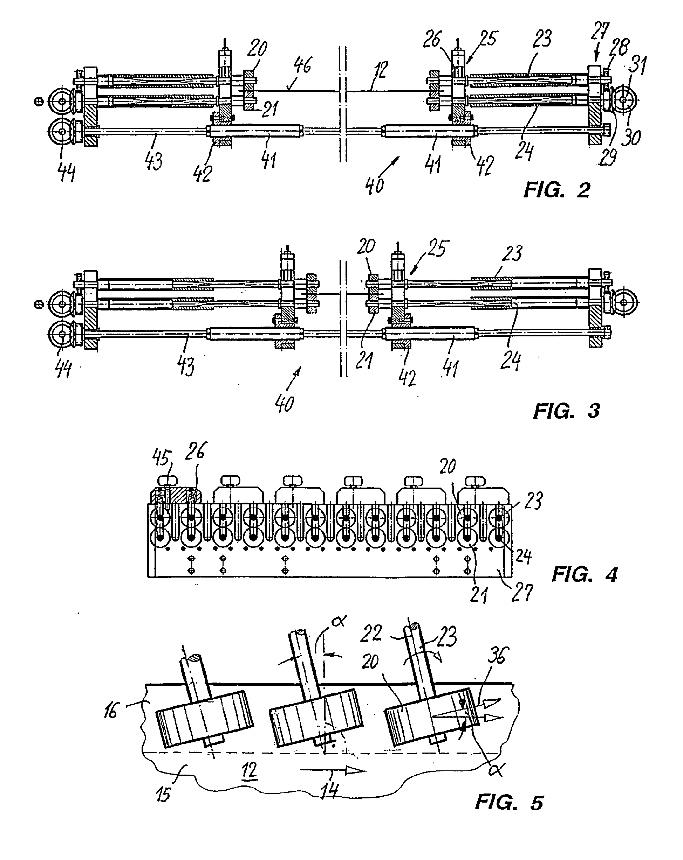

Die Rollenbahnen 17, 18 bestehen aus Rollenpaaren (siehe auch Fig. 2 bis 4) mit oberen Rollen 20 und unteren Rollen 21, die meist aus einem flexiblen Kunststoffmaterial bestehen, das gegen die verwendeten Chemikalien resistent ist und deren Lauf- bzw. Kontaktflächen mit einem guten Reibschluss an den Leiterplatten 12 angreifen. Die Rollen sind jeweils in Transportrichtung hintereinander mit relativ kurzem Abstand voneinander angeordnet, so dass ihre Achsen 22 einen Abstand zwischen den 1,2- und 2-fachen des Rollendurchmessers haben.

Jede Rolle wird von einer Welle 23 getragen, die zweiteilig ist und mittels eines Schiebesitzes längenveränderlich ist. In den Fig. 1 bis 3 ist dargestellt, dass die Rollen 20, 21 jeweils auf zwei senkrecht übereinander und parallel zueinander verlaufenden Wellen 23, 24 an deren frei auskragenden Wellenenden angeordnet sind. Die Wellen 23, 24 sind in einer Lagertraverse 25 gelagert, wobei die obere Welle 23 mit der Rolle 20 vertikal verschiebbar ist, und zwar entgegen der Kraft einer Andruckfeder 26, die für einen Kontaktdruck zwischen den Kontaktflächen der Rollen 20, 21 und den beiden Flachseiten der Leiterplatte 12 im Randbereich 16 sorgt.

Die den Rollen entgegengesetzten Enden der Teleskopwellen 23, 24 sind ebenfalls in einer Lagertraverse 27 gelagert und haben an ihren aus dieser frei herauskragenden Wellenenden Synchronisationszahnräder 28, die einen gegenläufigen synchronen Antrieb der axialen Wellen und damit der Rollen gewährleisten. Auf der unteren Welle 24 sitzt zudem ein Kegelrad 29, das mit einem Antriebskegelrad 30 zusammenwirkt, dass auf einer Synchron-Antriebswelle 31 angeordnet ist. Jedes Wellenpaar 23, 24 und damit jedes Rollenpaar 20, 21 hat einen solchen Antrieb, so dass alle Rollen mit der gleichen Drehzahl angetrieben sind. Die Synchronwellen 31 auf beiden Seiten der Behandlungseinrichtung 11 können von einem gemeinsamen Antrieb 32, z.B. über eine Kette oder einen Zahnriemen 33 angetrieben sein.

Die Fig. 1 zeigt eine Einheit mit insgesamt zwölf Rollensätzen auf jeder Seite. Bei längeren Behandlungseinrichtungen können mehrere solcher Einheiten oder Transportmodule hintereinander angeordnet sein, wobei die Synchronwellen über Kupplungen 34 miteinander verbunden sein können.

Die Achsen 22 der Wellen 23, 24 und damit der Rollen 20, 21 sind unter einem Winkel α, der bei einer bevorzugten Ausführung ca. 0,5° beträgt, jedoch, abhängig von den Gegebenheiten, zwischen 0,1° und 2° betragen kann, gegenüber einer Senkrechten 35 zur Transportrichtung 14 geneigt sind, und zwar so, dass die Abrollrichtung 36 der Rollen 20, 21 in Transportrichtung von dieser nach außen divergiert.

Dieser Spurwinkel α wird durch entsprechenden Versatz der Wellenlager in den Lagertraversen 25 und 27 in horizontaler Richtung zueinander erreicht. Er ist durch Verschiebung der Traversen etwa in Transportrichtung gegeneinander einstellbar, insbesondere, wenn die Wellen oder ihre Lager darin schwenkbar, z.B. mit Spiel, elastisch in Kugelführungen o.dgl. aufgenommen sind.

Da die Rollenpaare 20, 21 immer im Randbereich 16 der Leiterplatten 12 laufen sollen, ist ihr Abstand in horizontaler Richtung quer zur Transportrichtung 14 voneinander einstellbar. Dies wird aus den Fig. 2 und 3 ersichtlich. Fig. 2 zeigt eine Einstellung, die der größten zu transportierenden Leiterplattenbreite entspricht. Zur Einstellung ist eine Verstelleinrichtung 40 vorgesehen, die im dargestellten Beispiel mit Schraubspindeln 41 arbeitet, die in Stellmuttern 42 in den Lagertraversen 25 arbeitet. Die jeweils mit gegensinnigem Gewinde versehenen Schraubspindeln 21 sitzen auf einer gemeinsamen Stellwelle 43, die unter der Rolleneinheit hindurchläuft und am Ende über ein Kegelrad von einem gemeinsamen Stellantrieb 44 nach Art einer parallel unterhalb der Synchronantriebswelle 31 verlaufenden Welle verstellbar sind. Es sind auch andere Verstellmechanismen möglich, z.B. durch Ketten, Riemen, Hydraulik oder elektrische Stellmotoren.

Fig. 4 zeigt, dass die Wellen 23, 24 in den Traversen 26, 27 in nach oben offenen Schlitzen gelagert sind, so dass sie durch eine Federkraft oder durch ihr Eigengewicht gegeneinander und gegen die Leiterplatte gedrückt werden. Es ist dort auch die Andruckfeder 26 gezeigt, die diese Andruckkraft einstellbar macht, und zwar über eine Stellschraube 45.

Die Funktion der Vorrichtung nach den Fig. 1 bis 5 ist wie folgt:
Zum Betrieb der Vorrichtung wird diese durch Betätigung des Stellantriebs 44, entweder manuell oder über einen entsprechenden Stellmotor, beispielsweise einen elektrischen Schrittmotor (nicht dargestellt) auf die richtige Breite für die zu bearbeitende Leiterplatten 12 eingestellt. Dazu wird die Stellwelle 43 gedreht und durch die mit gegensinnigen Gewinden versehenen Stellspindeln 41 und Stellschrauben 42 bewegen sich die beiden Traversen 25 gegenläufig synchron aufeinander zu bzw. voneinander weg. Dies geschieht zwischen den beiden Extremstellungen Fig. 2 (breiteste Einstellung) und Fig. 3 (schmalste Einstellung). Die Wellen sind in den Traversen 25, 27 durch fest auf den Wellen sitzende Buchse auf reibungsarmem Material gelagert, die durch seitliche Flanschen oder Bünde eine Axialverschiebung gegenüber der Traverse verhindern.

Die sich teleskopartig ineinander schiebenden Wellenteile der Wellen 23, 24 erlauben diese Bewegung und ermöglichen infolge einer verdrehsicheren Führung der beiden Wellenteile aneinander, beispielsweise nach Art einer Keilwelle o.dgl., die Übertragung der Antriebsdrehung auf die Rollen.

Die Leiterplatten 12 laufen in Transportrichtung in das Transportmodul ein und werden in den dafür vorgesehenen Randbereich 16 von den Rollenbahnen erfasst und durch die Vorrichtung transportiert. Dabei sorgen die relativ eng zueinander stehenden Rollen für eine gleichmäßige horizontale Führung auf einer durch die Leiterplatten ebene gebildeten Transportbahn 46. Durch die Winkelstellung der Rollen und damit ihrer Abrollrichtung 36 gegenüber der Transportrichtung 14, die auf beiden Seiten der Leiterplatte jeweils entgegengesetzt wirkt, wird eine gewisse Zugspannung auf die Leiterplatten 12 aufgebracht, die die Leiterplatten strafft und somit gespannt und im wesentlichen eben, jedoch, abgesehen von den Randbereichen, berührungsfrei durch die Vorrichtung transportiert. Falls die Leiterplatten in ihrem Mittelbereich einen nicht nutzbaren Bereich haben, kann dort eine Auflage vorgesehen sein. Da über die Rollen bezüglich ihrer Anordnung in Transportrichtung hintereinander ausgerichtet sind, bleibt ihr Kontaktbereich zu den Leiterplatten auf diesen relativ schmalen Randbereich 16 beschränkt, wie aus der mit weit übertriebener Winkelstellung dargestellten Skizze Fig. 5 hervorgeht.

Infolge der Flexibilität der Rollen werden die geringen Querkomponenten der Rollenbewegung auf den Leiterplatten entweder durch Walken der flexiblen Rollen aufgenommen oder es entsteht eine geringfügige Rutschbewegung in Querrichtung, die jedoch der Leiterplatte nicht schadet, da der Randbereich ohnehin von der Nutzung ausgeschlossen ist.

Durch entsprechende Abschottungen im Bereich der Traversen, insbesondere der rollennäheren Lagertraverse 25, kann der eigentliche Behandlungsbereich, d.h. der Bereich der Füllung der Behandlungseinrichtung mit Flüssigkeit o.dgl. jeweils auf die Leiterbreite angepasst werden. Dies kann beispielsweise mit labyrinthartigen Dichtungen vorgenommen werden.

Bei der Ausführung nach den Fig. 1 bis 5 ist die Transportebene nicht nur in Transportrichtung, sondern auch in Querrichtung dazu horizontal. Mit der Vorrichtung nach der Erfindung ist es jedoch auch möglich, Flachmaterialien auf geneigten Transportbahnen zu führen. Bei einer in Querrichtung geneigten Transportbahn könnte beispielsweise durch unterschiedliche Winkelstellung der Rollenpaare auf beiden Seiten einer "Wanderneigung" der Leiterplatte in Richtung auf die unten liegende Seite entgegengewirkt werden. Eine solche Schräglage könnte beispielsweise wegen des besseren Ablaufens von Flüssigkeit gewählt werden. In diesem Falle wären vorzugsweise die Anstellwinkel der Rollen einzeln und unabhängig voneinander auf beiden Seiten einstellbar.

Fig. 6 und 7 zeigen, ebenfalls in zwei verschiedenen Breiteneinstellungen, eine andere Ausbildung der Transportmittel 19 und der Verstelleinrichtung 40. Die rollennahe Traverse 25 ist fest, d.h. nicht mit der Verstelleinrichtung verschiebbar. Dafür ist eine weitere Stelltraverse 47 vorgesehen, die die obere Welle 23 der Rolle 20 an ihrem Ende lagert, und zwar in mittels einer Lagerbuchse 48, die die Welle 23 in Axialrichtung unverschiebbar in dem Lagerschlitz 53 der Traverse 47 lagert, während sich die Welle in einer drehbar auf der Welle sitzenden Lagerhülse 49 in der Traverse 25 axial verschieben kann. Die untere Welle 24 ist im Gegensatz zu der einteiligen Welle 23 zweiteilig, wie in Fig. 1 bis 3 gezeigt, wobei die beiden Teile 24a und 24b teleskopartig ineinander schiebbar sind. Eine Nut 50 im Wellenteil 24a arbeitet mit einem Führungsstift 51 in dem rohrförmigen Wellenteil 24b zur Axial-Verdrehsicherung zusammen. Der Wellenteil 24 ist mittels einer Lagerbuchse 49, die sich mit dem Wellenteil 24b in der Traverse 47 dreht, zu dieser axial gesichert geführt. In der Traverse 25 führt sich dieser Wellenteil unmittelbar in einem Schlitz 53 entsprechend dem in Fig. 4 dargestellten.

Bei dieser Ausführung ist nur die untere Welle 24 und dementsprechend die untere Rolle 21 unmittelbar angetrieben, und zwar über die Kegelräder 29, 30 von der Synchronwelle 31. Die obere Welle 23 wird mittelbar über die Leiterplatte 12 von der unteren Rolle 21 drehend mitgenommen, was in vielen Fällen ausreichend ist. Es ist auch möglich, nur einige der Rollenpaare anzutreiben, während die übrigen Rollenpaare von der Leiterplatte mittelbar angetrieben werden. Auf die die Leiterplatte spannende Spreizwirkung hat dies keinen wesentlichen Einfluss. Infolge der relativ kleinen aufzubringen Kräfte und der Tatsache, dass die gesamten Transportmittel normalerweise von Flüssigkeit benetzt sind, sowie wegen der aus Gründen der chemischen Beständigkeit notwendigen Herstellung aus hochwertigen Kunststoffen bzw. besonders veredelten Metallen ist ein leichter Lauf gewährleistet.

Die Verstelleinrichtung 40 besteht bei Fig. 6 und 7 ebenfalls aus einer Stellmutter 41 auf einer Stellwelle 43, die jedoch in der Traverse 25 nur drehbar gelagert ist. Die entsprechende Stellmutter 42 ist in der querbeweglichen Traverse 47 angebracht, die zur Breiteneinstellung beweglich ist. Dabei ist zu erkennen, dass die Rollen 20, 21 zusammen mit ihren Wellen durch die Traverse 25 hindurch zur Mitte hin geschoben werden und dementsprechend weiter oder weniger weit über die Traverse 25 auskragen.

Es wäre auch andere Verstelleinrichtungen und Rollenantriebe denkbar, beispielsweise über Zahnriemen, die von oben her in die Behandlungseinrichtung hineingreifen und mit einem zusammen mit den Rollen verstellbaren Antrieb zusammenarbeiten. Durch die dargestellte Verstelleinrichtung ist es jedoch möglich, den Antrieb stationär an beiden Seiten der Behandlungseinrichtung vorzusehen, und zwar sowohl den Verstellantrieb als auch den Rollenantrieb, so dass man diese Teile außerhalb der eigentlichen Behandlungskammer, d.h. vor aggressiven Chemikalien, weitgehend geschützt, anordnen kann.

Es wurde vorstehend deutlich, dass durch die Beeinflussung der Rollenlaufrichtung gegenüber der Transportrichtung, und zwar auf beiden Seiten gegenläufig, eine Zugspannung auf die zu transportierenden Flachmaterialien aufgebracht werden kann. Sie ist durch die Winkelstellung einerseits und durch die Anpressung der Rollenpaare aneinander andererseits bestimmt und einstellbar. Dadurch ist es möglich, diese Flachmaterialien in ihrem nutzbaren Bereich 15 berührungslos durch eine Vorrichtung zu führen, obwohl sie selbst flexibel und sozusagen "lappig" sind. Es ist vor allem möglich, die Materialien während ihrer Behandlung Kräften auszusetzen, die beispielsweise von durch Sprühdüsen ausgebrachte Flüssigkeit auf sie einwirken, ohne dass sie dadurch von der Transportebene abgelenkt werden.

Bei etwas steiferen Materialien wäre es auch möglich, durch Aufbringung einer gewissen Druckkraft eine Versteifung herbeizuführen. Eine solche Möglichkeit ist in Fig. 8 skizzenhaft dargestellt. Zwischen zwei Rollenpaaren 20, 21 auf beiden Seiten des Behandlungsbereiches wird das Flachmaterial (Leiterplatte) 12 in eine aufwärts gerichtete Bogenform gebracht. Dazu sind die Rollen mit aufwärts gerichtet schräg stehenden Achsen 22 angeordnet. Eine in Fig. 8 nicht dargestellte Winkelanstellung der Rollen gegenüber der Transportrichtung, jedoch etwas nach innen gerichtet (im Gegensatz zu Fig. 1 bis 7), sorgt dafür, dass die Leiterplatte 12 nicht durch die aufgebrachte Druckkraft zwischen den Rollen nach außen wandert.

Eine solche gewölbte Transportbahn 46a versteift das Flachmaterial und sorgt gleichzeitig dafür, dass bei einer Behandlung durch Aufsprühen einer Flüssigkeit diese gut ablaufen kann, ohne Lachen auf der Oberfläche zu bilden, die zu ungleichmäßigen Behandlungsergebnissen führen könnten.

## Patentansprüche

1. Vorrichtung zum Transport von flexiblen platten- bzw. blattförmigem Flachmaterial (12), insbesondere Leiterplatten, in Behandlungseinrichtungen (11), mit Transportmitteln (19), die das Flachmaterial (12) erfassen und in einer Transportrichtung (14) auf einer Transportbahn (46) transportieren, wobei die Transportmittel (19) zur Aufbringung einer das Flachmaterial (12) versteifenden, im wesentlichen quer zur Transportrichtung (14) gerichteten Spannung ausgebildet sind, **dadurch gekennzeichnet, dass** die Transportmittel (19) Rollenbahnen (17, 18) mit Rollenpaaren (20, 21) enthalten, die auf den einander quer zur Transportrichtung (14) gegenüberliegenden Randbereichen (16) abrollbare Kontaktflächen aufweisen, die das Flachmaterial (12) von beiden Flachseiten her unter einem Kontaktdruck kontaktieren, wobei die Rollen (20, 21) Achsen (22) aufweisen, die unter einem Winkel (α) gegenüber der Senkrechten (35) zur Transportrichtung (14) angeordnet sind, und wobei in Transportrichtung (14) aufeinander folgende Rollenpaare (20, 21) im wesentlichen in dem parallel zur Transportrichtung verlaufenden Randbereich (16) des Flachmaterials laufen.

2. Vorrichtung nach Anspruch 1, **dadurch gekennzeichnet, dass** die Rollenpaare (20, 21) in Transportrichtung (14) hintereinander, jedoch winkelmäßig angestellt, angeordnet sind.

3. Vorrichtung nach Anspruch 1 oder 2, **dadurch gekennzeichnet, dass** der Winkel (α) eine Größe von 0,1° bis 2°, insbesondere 0,5°, hat.

4. Vorrichtung nach einem der vorhergehenden Ansprüche, **dadurch gekennzeichnet, dass** zur Aufbringung einer Zugspannung auf das Flachmaterial (12) die Winkelabweichung (α) derart ist, dass die Abrollrichtung (36) der Rollen (20, 21) gegenüber der Transportrichtung (14) nach außen gerichtet ist.

5. Vorrichtung nach einem der Ansprüche 1 bis 3, **dadurch gekennzeichnet, dass** zur Aufbringung einer das Flachmaterial (12) in eine gewölbte Form bringenden Druckspannung die Transportmittel Kontaktflächen aufweisen, die das Flachmaterial unter einen Winkel zur Ebene des Flachmaterials erfassen.

6. Vorrichtung nach einem der vorhergehenden Ansprüche, **dadurch gekennzeichnet, dass** die Transportmittel (19) beidseitig der Transportbahn (46) je eine Rollenbahn (17, 18) zumindest teilweise angetriebener, unter Kontaktdruck zusammenwirkender Rollenpaare (20, 21) aufweisen, deren sie tragende Wellen (23, 24) mit einer Abstands-Verstelleinrichtung (40) zur Einstellung des Abstandes der beidseitigen Rollenbahnen (17, 18) voneinander verbunden sind.

7. Vorrichtung nach einem der vorhergehenden Ansprüche, **dadurch gekennzeichnet, dass** die Rollenbahnen (17, 18) jeweils synchron entgegengesetzt verstellbar sind.

8. Vorrichtung nach einem der vorhergehenden Ansprüche, **dadurch gekennzeichnet, dass** die Abstands-Verstelleinrichtung (40) eine die die Rollen tragenden Wellen (23, 24) führende, im wesentlichen quer zur Transportrichtung verschiebbare Traverse (25; 47) aufweist, wobei vorzugsweise wenigstens angetriebene Wellen (23, 24) der Rollen (20, 21) längenveränderlich sind und je Seite von einem gemeinsamen Antriebsstrang (31) angetrieben sind.

9. Vorrichtung nach Anspruch 8, **dadurch gekennzeichnet, dass** die Wellen (23, 24) in zwei gegeneinander verschiebbaren Traversen (25, 27; 47) geführt sind, von denen eine verschiebbar ist und die Wellen (23, 24) radial und auch axial führt, wobei entweder die den Rollen am nächsten liegende Traverse (25) verschiebbar ist und bei ihrer Verschiebung ihr Abstand zu den Rollen (20, 21) im wesentlichen gleich bleibt oder die verschiebbare Traverse (47) von den Rollen entfernter liegt und die Wellen (23, 24b) durch die feste Traverse (25) hindurch längsverschiebbar sind.

10. Vorrichtung nach einem der vorhergehenden Ansprüche, **dadurch gekennzeichnet, dass** wenigstens einige der Rollenpaare (20, 21) angetrieben sind.

11. Vorrichtung nach einem der vorhergehenden Ansprüche, **dadurch gekennzeichnet, dass** der Antrieb jedes Rollenpaars (20, 21) von einem für alle Rollenpaare einer Seite gemeinsamen Antriebsstrang (31), wie einer Kegelräder (29) aufweisenden Synchronwelle, einem Riemen- oder Kettenantrieb, angetrieben ist.

12. Vorrichtung nach einem der vorhergehenden Ansprüche, **dadurch gekennzeichnet, dass** die Wellen (23, 24) beider Rollen (20, 21) eines Rollenpaares gegenläufig synchron angetrieben sind, vorzugsweise durch einen Synchronradsatz (28) von einem gemeinsamen Antrieb (31) aus.

13. Vorrichtung nach einem der vorhergehenden Ansprüche, **dadurch gekennzeichnet, dass** nur eine Rolle (21) eines Rollenpaares (20, 21) von ihrer Welle (24a, 24b) her angetrieben ist und die andere Rolle (20) durch Reibschluss über das Flachmaterial (12) von der direkt angetriebenen Rolle (21) des Paares her angetrieben ist.

14. Vorrichtung nach einem der vorhergehenden Ansprüche, **dadurch gekennzeichnet, dass** die Verstelleinrichtung (40) ggf. mehrere von einer gemeinsamen Verstellwelle (44) angetriebene Bewegungsschrauben (41) aufweist, die mit den verschiebbaren Traversen (25; 47) zu deren gleichsinniger synchroner Verstellung verbunden sind.

15. Vorrichtung nach einem der vorhergehenden Ansprüche, **dadurch gekennzeichnet, dass** der Winkel (α) einstellbar ist, vorzugsweise für alle Rollen (20, 21) einer Rollenbahn (17, 18) und insbesondere für beide Rollenbahnen, gemeinsam.

## Claims

1. A device for the transport of flexible plate-like or sheet-like planar material (12), in particular circuit boards, into treatment devices (11), comprising transport means (19), which grip the planar material (12) and transport it in a transporting direction (14) onto a transport conveyor (46), whereby the transport means (19) is designed to apply a tension reinforcing the planar material (12) and directed essentially transversely with respect to the transporting direction (14), **characterized in that** the transport means (19) house roller tracks (17, 18) with pairs of rollers (20, 21), which have contact surfaces, which can roll on the boundary regions (16) lying opposite one another transversely with respect to the transporting direction (14), which contact surfaces contact the planar material (12) from both planar sides under a contact pressure, whereby the rollers (20, 21) have axes (22), which are arranged at an angle (α) relative to the vertical (35) with respect to the transporting direction (14), and whereby pairs of rollers (20, 21) following one another in transporting direction (14) run essentially in the boundary region (16) of the planar material, which boundary region (16) extends parallel to the transporting direction.

2. The device according to claim 1, **characterized in that** the pairs of rollers (20, 21) are arranged one behind the other in transporting direction (14), however, angularly pitched.

3. The device according to claim 1 or 2, **characterized in that** the angle (α) has a size of 0.1° to 2°, in particular 0.5°.

4. The device according to any of the preceding claims, **characterized in that** for applying a tensile force onto the planar material (12) the angle deviation (α) is such that the rolling direction (36) of the rollers (20, 21) relative to the transporting direction (14) is directed outwardly.

5. The device according to any of claims 1 to 3, **characterized in that** for applying a compressive strain changing the planar material (12) into an arched form the transport means have contact surfaces, which grip the planar material at an angle relative to the plane of the planar material.

6. The device according to any of the preceding claims, **characterized in that** the transport means (19) have on both sides of the transport conveyor (46) each one roller track (17, 18) of at least partly driven pairs of rollers (20, 21), which cooperate under contact pressure, and the shafts (23, 24) of which, which carry them, are connected to a space adjusting device (40) for adjusting the distance between the roller tracks (17, 18) on both sides.

7. The device according to any of the preceding claims, **characterized in that** the roller tracks (17, 18) can each be synchronously oppositely adjusted.

8. The device according to any of the preceding claims, **characterized in that** the space adjusting device (40) has a traverse (25; 47), which guides the shafts (23, 24) carrying the rollers and is essentially movable transversely relative to the transporting direction, whereby preferably at least driven shafts (23, 24) of the rollers (20, 21) are changeable in length and are driven per side by a common drive line (31).

9. The device according to claim 8, **characterized in that** the shafts (23, 24) are guided in two traverses (25, 27; 47), which can be moved toward one another, and of which one is movable and guides the shafts (23, 24) radially and also axially, whereby either the traverse (25) closest to the rollers is movable and during its movement its distance from the rollers (20, 21) remains essentially the same, or the movable traverse (47) is farther from the rollers and the shafts (23, 24) are longitudinally movable through the fixed traverse (25).

10. The device according to any of the preceeding claims, **characterized in that** at least some of the pairs of rollers (20, 21) are driven.

11. The device according to any of the preceeding claims, **characterized in that** the drive of each pair of rollers (20, 21) is driven by a drive line (31) common for all pairs of rollers on one side, like a synchronous shaft having bevel gears (29), a belt or chain drive.

12. The device according to any of the preceeding claims, **characterized in that** the shafts (23, 24) of both rollers (20, 21) of a pair of rollers are oppositely directed synchronously driven, preferably through a synchronous set of wheels (28) by a common drive (31).

13. The device according to any of the preceeding claims, **characterized in that** only one roller (21) of a pair of rollers (20, 21) is driven by its shaft (24a, 24b), and the other roller (20) is driven through frictional engagement through the planar material (12) by the directly driven roller (21) of the pair.

14. The device according to any of the preceeding claims, **characterized in that** the adjusting device (40) has, if necessary, several leading screws (41) driven by a common adjusting shaft (44), which leading screws (41) are connected to the movable traverses (25; 47) for their synchronous adjustment in the same direction.

15. The device according to any of the preceeding claims, **characterized in that** the angle (α) is adjustable, preferably for all rollers (20, 21) of a roller track (17, 18) and in particular for both roller tracks together.

## Revendications

1. Dispositif pour le transport de matériaux plats (12) flexibles sous forme de plaque ou encore de feuille, notamment de cartes imprimées, dans des dispositifs de traitement (11), présentant des moyens de transport (19) qui saisissent le matériau plat (12) et le transportent dans une direction de transport (14) sur une voie de transport (46), sachant que les moyens de transport (19) sont réalisés de manière à pouvoir produire une tension, qui est orientée essentiellement en direction transversale par rapport à la direction de transport (14) et qui raidit le matériau plat (12), **caractérisé en ce que** les moyens de transport (19) comprennent des voies de rouleaux (17, 18) avec des paires de rouleaux (20, 21), qui présentent des surfaces de contact, qui roulent sur les domaines marginaux (16) opposés l'un par rapport à l'autre en direction transversale à la direction de transport (14) et qui créent un contact mécanique avec le matériau plat (12) des deux côtés de la surface plate, sous l'effet d'une pression de contact, sachant que les rouleaux (20, 21) présentent des axes (22), qui sont disposés sous un angle (α) par rapport à la verticale (35) par rapport à la direction de transport (14), et sachant que des paires de rouleaux (20, 21) consécutifs en direction de transport (14) roulent essentiellement dans le domaine marginal (16) du matériau plat, qui s'étend parallèlement à la direction de transport.

2. Dispositif d'après la revendication 1, **caractérisé en ce que** les paires de rouleaux (20, 21) sont disposées l'une derrière l'autre en direction de transport (14) mais sous un certain angle d'incidence.

3. Dispositif d'après la revendication 1 ou 2, **caractérisé en ce que** l'angle (α) s'élève à 0,1° jusqu'à 2°, notamment à 0,5°.

4. Dispositif d'après une des revendications précédentes, **caractérisé en ce que** pour appliquer une tension de traction sur le matériau plat (12) l'écart angulaire (α) est tel que la direction de roulement (36) des rouleaux (20, 21) par rapport à la direction de transport (14) est orientée vers l'extérieur.

5. Dispositif d'après une des revendications de 1 à 3, **caractérisé en ce que** pour appliquer une contrainte de compression, afin que le matériau plat (12) présente une forme bombée, les moyens de transport présentent des surfaces de contact, qui saisissent le matériau plat sous un angle par rapport au plan du matériau plat.

6. Dispositif d'après une des revendications précédentes, **caractérisé en ce que** les moyens de transport (19) présentent des deux côtés de la voie de transport (46) respectivement une voie de rouleaux (17, 18) avec des paires de rouleaux (20, 21) actionnées au moins en partie de manière conjointe et agissant sous l'effet d'une force de contact, dont les arbres (23, 24) qui les portent sont raccordés par un dispositif de réglage d'écart (40) pour le réglage de l'écart entre les voies de rouleaux (17, 18) sur les deux côtés.

7. Dispositif d'après une des revendications précédentes, **caractérisé en ce que** les voies de rouleaux (17, 18) sont ajustables de manière respectivement opposée et synchrone.

8. Dispositif d'après une des revendications précédentes, **caractérisé en ce que** le dispositif de réglage d'écart (40) présente une traverse (25 ; 47) qui conduit les arbres (23, 24) portant les rouleaux et qui est déplaçable en direction essentiellement transversale par rapport à la direction de transport, sachant que de préférence au moins des arbres (23, 24) menés des rouleaux (20, 21) sont modifiables dans leur longueur et menés de chaque côté par un brin d'actionnement (31) en commun.

9. Dispositif d'après la revendication 8, **caractérisé en ce que** les arbres (23, 24) sont menés dans deux traverses (25, 27 ; 47) déplaçables l'une par rapport à l'autre, dont l'une est déplaçable et conduit les arbres (23, 24) radialement et axialement, sachant qu'ou bien la traverse (25) la plus proche des rouleaux est déplaçable et que pendant sont déplacement son éloignement des rouleaux (20, 21) reste essentiellement le même, ou bien la traverse (47) déplaçable est plus éloignée des rouleaux et les arbres (23, 24b) sont déplaçables en direction longitudinale à travers la traverse (25) fixe.

10. Dispositif d'après une des revendications précédentes, **caractérisé en ce qu'**au moins certaines des paires de rouleaux (20, 21) sont actionnées.

11. Dispositif d'après une des revendications précédentes, **caractérisé en ce que** l'actionnement de chaque paire de rouleaux (20, 21) est mené par un brin d'actionnement (31) commun pour toutes les paires de rouleaux d'un côté, tel qu'un arbre synchrone présentant des pignons coniques (29), une commande à courroie ou à chenille.

12. Dispositif d'après une des revendications précédentes, **caractérisé en ce que** les arbres (23, 24) des deux rouleaux (20, 21) d'une paire de rouleaux sont actionnés de manière synchrone mais contraire, de préférence par un train de roues synchrones (28) à partir d'un actionnement (31) commun.

13. Dispositif d'après une des revendications précédentes, **caractérisé en ce qu'**un rouleau (21) seulement d'une paire de rouleaux (20, 21) est actionné à partir de son arbre (24a, 24b) et que l'autre rouleau (20) est entraîné par friction au moyen du matériau plat (12) par le rouleau (21) de la paire actionné directement.

14. Dispositif d'après une des revendications précédentes, **caractérisé en ce que** le dispositif de réglage d'écart (40) présente éventuellement plusieurs vis d'avance (41) qui sont actionnées en commun par un arbre d'ajustage (44) et qui sont raccordées par les traverses (25 ; 47) déplaçables pour leur réglage synchrone dans le même sens.

15. Dispositif d'après une des revendications précédentes, **caractérisé en ce que** l'angle (α) peut être ajusté, de préférence conjointement pour tous les rouleaux (20, 21) d'une voie de rouleaux (17, 18) et notamment pour les deux voies de rouleaux.
